**Europäisches Patentamt**

**European Patent Office**

**Office européen des brevets**

(19)

(11) Publication number: **0 047 764**
**B1**

(12) # EUROPEAN PATENT SPECIFICATION

(45) Date of publication of patent specification: **17.10.84**

(51) Int. Cl.³: **G 01 B 7/30, B 25 J 19/00**

(21) Application number: **81900661.0**

(22) Date of filing: **20.03.81**

(86) International application number:
**PCT/NO81/00007**

(87) International publication number:
**WO 81/02780 01.10.81 Gazette 81/23**

(54) **A DEVICE FOR POSITION MEASUREMENT.**

(30) Priority: **21.03.80 NO 800827**

(43) Date of publication of application:
**24.03.82 Bulletin 82/12**

(45) Publication of the grant of the patent:
**17.10.84 Bulletin 84/42**

(84) Designated Contracting States:
**DE FR GB SE**

(56) References cited:
**US-A-3 984 672**
**US-A-4 099 245**

(73) Proprietor: **TRALLFA Underhaug A/S**
**Postboks 113**
**N-4341 Bryne (NO)**

(72) Inventor: **KJOSAVIK, Dag**
**Veslevegen**
**N-4300 Sandnes (NO)**

(74) Representative: **Modin, Jan et al**
**c/o Axel Ehrners Patentbyra AB Box 5342**
**S-102 46 Stockholm (SE)**

Courier Press, Leamington Spa, England.

## Description

The present invention relates to a device for position measurement or angular measurement of the kind indicated in the preamble of claim 1 or claim 2.

Synchros are used as measuring devices for measuring angles, inter alia for remote read-off (i.e. electrical transfer of angle from the measured location to the indicating instrument), transfer of moments, usually small, and remote control of servo mechanisms.

When the angular measurement is desired to be converted into digital information, there is used a resolver which is particular type of synchro. The resolver consists of two stator windings which are shifted by 90° and one or two rotor windings.

The resolver is supplied with A.C. voltage (e.g. 400 Hz) and this can be carried out in one of two ways:

a. Feeding the two stator windings with $E \cdot \sin \omega t$ and $E \cdot \cos \omega t$, respectively. There is then induced in the rotor windings: $k \cdot E \cdot (\sin \omega t \cdot \sin \theta + \cos \omega t \cdot \cos \theta) = k \cdot E \cdot \sin (\omega t - \theta)$, k being a constant, i.e. phase modulated signal with constant amplitude. The phase modulated signal may be converted into digital form by means of a demodulator.

b. Feeding the rotor winding with $E \cdot \sin \omega t$. There is then in the sine winding induced: $k \cdot E \sin \omega t \cdot \sin \theta$, and in the cosine winding: $k \cdot E \sin \omega t \cdot \cos \theta$. This latter method is the most frequently used one today and conversion into digital signals can be effected in different ways.

Use of resolvers for angular measurement competes in digital systems with code disks giving direct digital angular read-off.

Parellel to the development of the code disks, the resolver-digital-converters have developed in such a direction that the resolvers still are to be preferred where great resolution (e.g. greater than 10 bits per resolution) is necessary.

Most of the available resolver-digital converters are based on the resolver making use of solution b above, and the most frequently used converter is the so-called "tracking" converter. US—A—3 894 672 contains a disclosure of a so-called "solid state transformer" forming a part of such a "tracking" converter. The transformer comprises a subtraction unit designed to generate a difference signal representative of the difference between $\theta$ and $\phi$, where $\phi$ denotes the desired angular position. For this purpose, the subtraction unit includes a quadrant selector, two multiplying units multiplying the output signals from the quadrant selector by signals corresponding to $\cos \phi$ and $\sin \phi$, respectively, and a differential amplifier, the putput of which constitutes the difference signal. The inputs of the subtraction unit are an analog input representing $\theta$, on the one hand, and a digital input representing $\phi$, on the other hand, the latter being digitally programmed (see US—A—3 984 672, column 11, line 19).

Tracking converters provide high static accuracy, are insensitive to frequency, phase and amplitude variations, as well as high frequency noise on the resolver signals, and provide good tracking of rapidly rotating resolver (NB velocity ≈ constant), and enables direct angular read-off.

Another widely used construction is the so-called Successive-approximation-converter. It operates almost like the tracking converter, but instead of continuous read-off of the resolver signals, these are sampled once or twice per period. A DC voltage signal representing sine of $\theta - \phi$ is formed by a sine and cosine multiplication and subtraction and said signal is applied to a quick operating analogue/digital converter which includes a Successive-approximation register. Successive-approximation converters enable rapid conversion, which permits relative rapid changes of the resolver speed, and direct angular read-off.

A more recent construction converting several channels is the micro-processor-based system MN7200 (micro Networks). The operation (for one channel) is as following: Sine and cosine signals are demodulated (AC/DC) and converted into digital form separately. The micro-processor thereby receives sine and cosine of the resolver angle.

In the processor there is calculated

$$\tan \theta = \frac{\sin \theta}{\cos \theta}$$

and thereafter $\theta$ is derived by means of an arc tan table and by interpolation. Said system is somewhat expensive, since there is required one AC/DC converter for each channel. In addition very small speed of the resolver (10°/sec.) is acceptable before accuracy is reduced.

The said system MN2700 provides great static accuracy, is insensitive to noise and is multiplexed for several channels.

The necessity for position measurement on several axes on e.g. a robot arm, where the requirements to accuracy, speed and low cost are great, has made it necessary to develop a new system where the advantages of the different said constructions are used.

The device according to the invention is set out in Claims 1 and 2, respectively. Its features also appear from the description hereinafter with reference to the accompanying drawings.

Fig. 1 is a block diagram of the device according to the invention.

Fig. 2 is a solid-state control transformer which may constitute the subtraction unit incorporated in the device.

Fig. 3 is a demodulator incorporated in the device.

Fig. 4 illustrates as an example output signals from the control transformer during a measuring cycle.

Fig. 5 is an alternative solution of the subtraction unit.

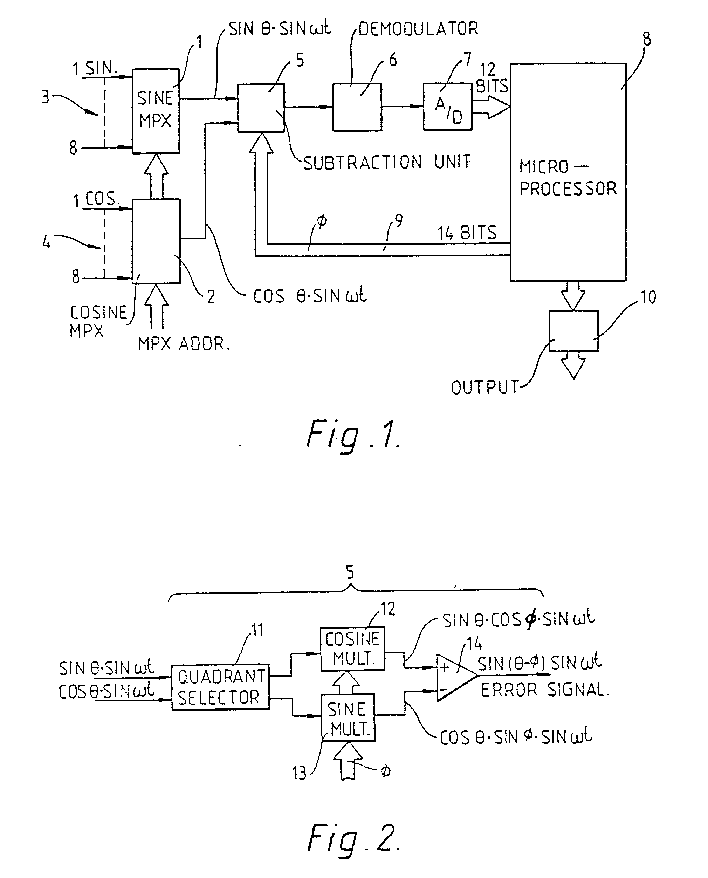

In fig. 1 there is shown input multiplexers 1, 2, for the inputs 3 and 4, respectively. The input 3 has in the example the form $\sin \theta \cdot \sin \omega t$ and 4 has in the example the form $\cos \theta \cdot \sin \omega t$, where $\theta$ is the turning angle of the resolver and $\omega$ is the angular frequency of the supplied carrier signal to the resolver. The multiplexers are fed with a multiplex address MPX · ADR in order to be able to alternate between a number of channels, eight in the chosen example. There may of course be more or less, dependent on the number of resolvers to be monitored. A subtraction unit 5 (SUB) has its two inputs connected to the respective multiplexers 1, 2.

The subtraction unit 5 may be a so-called solid state control transformer corresponding to a part of a tracking-converter, viz. quadrant selector 11, multipliers 12 and 13 for cosine and sine of $\phi$, respectively, and difference amplifier 14, see fig. 2.

The said multipliers are special sine and cosine multipliers. Alternatively, these may be conventional linear multiplying digital-to analogue converters 18, 19 which must be fed with sine $\phi$ and cosine $\phi$, respectively, through latches 20, 21 which are connected to a data bus and thereby to a micro-processor. In this case, it is the micro-processor which has to calculate sine $\phi$ and cosine $\phi$.

When the micro-processor 8 estimates correct angular position, the theoretical error signal from the difference amplifier should be equal to zero.

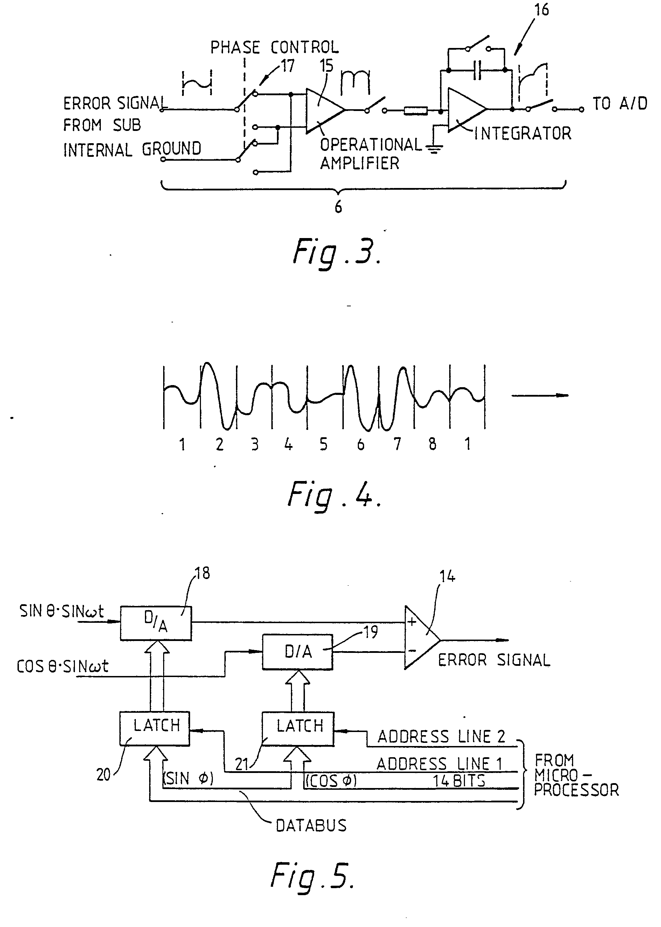

The output from the subtraction unit 5 is connected to a demodulator 6, which is shown in further detail in fig. 3. The demodulator consists of a commutator based on electronic switches 17, an operational amplifier 15, and an integrator 16 which may be zero set.

The output from the demodulator 6 is connected to an analogue/digital converter 7, the output of which feeds the micro-processor 8 with data representing $\sin (\theta - \phi)$ of e.g. format 12 bits.

The system may according to a preferred embodiment operate with up to 8 resolvers. Each of these are connected during a complete period of the carrier frequency by means of the input multiplexers. The carrier frequency is e.g. 1 kKz. The subtraction unit 5 operates thereby one millisecond for each resolver. The digital input to the subtraction unit also obtains a new value for each period, such that the output signal from the subtraction circuit may look like that shown in fig. 4.

If we look on the conversion for one channel, the operation is as follows. The sampling points are indicated by $(k - 1)$, $(k)$, $(k + 1)$ as the former, the present and the next sample, respectively. The angle of the resolver is $\theta$ and the estimated angle of the micro processor is $\phi$. After a period (1 ms) where the estimated value is $\phi(k - 1)$, $\sin [\theta - \phi(k - 1)]$ is measured, de-

noted as $\sin (\theta - \phi) (k)$.

The micro processor 8 calculates $\phi(k) = f\{[\phi(k - 1)], \sin [\theta - \phi)(k)]\}$ and the said function may in its simplest form be a summation, since sine of small angles is approximately equal to the angle itself. $\phi(k)$ will represent the resolver angle (in digital form) when the system has "moved into position".

Thus, the micro-processor provides a continuous calculation of assumed correct position based on the regular data which are supplied. An output unit 10 is connected to micro-processor 8, from which unit the correct positional data may be further used.

Absolute measurement accuracy is limited by the subtraction unit, whereas the measurement resolution is not limited thereby, since the error signal $\sin (\theta - \phi)$ is an analog signal. The subtraction unit may e.g. have a 14 bit digital input and the A/D-converter for the error signal may provide 12 bits. Dependent on the amplification in the demodulator, these 12 bits may represent the angular difference with high or small resolution. The limiting factor in this respect is the maximum speed of the resolver relative to the sampling frequency. High resolution is very important for stabilization of the servo systems. In the present system the resolution is e.g. one quarter of the resolution of the data word which the subtraction unit is fed with (here: $\phi$).

The system can compensate for velocity errors in the resolver and eliminate tracking errors at relative large velocities of the resolver. This is based on the forming of the said function $\phi(k)$.

Dynamic accuracy is limited by the number of resolvers which are connected, but time delays in the measurement of each single resolver due to the multiplexing does not influence the measurement. This is due to the fact that $\sin (\theta - \phi)(k)$ is measured during the last period (of the carrier frequency) before calculations of $\phi(k)$ are made, even though $\phi(k - 1)$ is e.g. "10 periods old".

The immunity to noise from the tracking converter is almost maintained, since the measurement takes place as an average over the complete period of the signals.

The system is cheap inter alia because, there is required one subtraction unit (price approximately equal that of a tracking converter) up to 8 channels, the A/D-converter capacity is only used in an amount of 2.5%, enabling other analogue measurements to be made (e.g. acceleration, power, velocity, pressure, temperature, position transmitters (DC) or the like), the micro-processor may be the same which controls e.g. the servo system. In addition there may be used cheap conventional components.

**Claims**

1. An apparatus for measuring the position of servo controlled mechanical members, e.g. of manipulators of industrial robots, comprising:

(a) a plurality of angular position transducers in the form of synchros or resolvers associated with said members, each said transducer providing two a.c. output signals modulated by factors representative of the sine and the cosine, respectively, of the instantaneous angular position $\theta$ of this transducer.

(b) a subtraction unit (5) generating for each transducer a difference signal representative of the difference between $\theta$ and $\phi$ where $\phi$ denotes the desired angular position of the respective transducer, said subtraction unit having

(i) a quadrant selector (11) receiving the said a.c. output signals,

(ii) two multiplying units (12, 13) multiplying the two output signals from the quadrant selector by signals corresponding to sin $\phi$ and cos $\phi$, respectively,

(iii) a differential amplifier (14) whose inputs are connected to the outputs of the multiplying units,

(c) a demodulator (6) for demodulating the said difference signal,

(d) a signal evaluation circuit (7, 8, 10) receiving the demodulated difference signal and supplying to the subtraction unit (5) the said signal representative of $\phi$,

(e) multiplexing means (1, 2) connecting the transducers one at a time on the subtraction unit, characterized in that

(f) the multiplexing means comprise a first and a second multiplexer (1, 2) receiving the sine and the cosine modulated a.c. output signals, respectively,

(g) the signal evaluation circuit comprises an A/D-converter (7) connected to the output of the demodulator (6), and a microprocessor (8) connected to the output of the A/D-converter (7), said microprocessor calculating the desired angular position $\phi$, the corresponding digital value being supplied via a data bus (9) to the said multiplying units (12, 13).

2. An apparatus for measuring the position of servo controlled mechanical members, e.g. of manipulators or industrial robots, comprising:

(a) a plurality of angular position transducers in the form of synchros or resolvers associated with said members, each said transducer providing two a.c. output signals modulated by factors representative of the sine and the cosine, respectively, of the instantaneous angular position $\theta$ of this transducer,

(b) a subtraction unit (5) generating for each transducer a difference signal representative of the difference between $\theta$ and $\phi$ where $\phi$ denotes the desired angular position of the respective transducer,

(c) a demodulator (6) for demodulating said difference signal,

(d) a signal evaluation circuit (7, 8, 10) receiving the demodulated difference signal and supplying to the subtraction unit (6) the said signal representative of $\phi$,

(e) multiplexing means (1, 2) connecting the transducers one at a time to the subtraction unit, characterized in that

(f) the multiplexing means comprise a first and a second multiplexer (1, 2) receiving the sine and the cosine modulated a.c. output signals, respectively,

(g) the signal evaluation circuit comprises an A/D-converter (7) connected to the output of the demodulator (6), and a microprocessor (8) connected to the output of the A/D-converter (7), said microprocessor calculating the desired angular position $\phi$,

(h) the subtraction unit (5) comprises:

(i) two latches (20, 21) connected to the microprocessor (8) by means of a data bus (9) supplying digital values representing the sine and cosine of the calculated desired angular position $\phi$,

(ii) two linear D/A-converters (18, 19) multiplying the said sine and cosine modulated a.c. output signals by the said digital cosine and sine values, respectively, after D/A-conversion thereof,

(iii) a differential amplifier (14) the inputs of which are connected with the outputs of said multiplying D/A-converters (18, 19).

3. A device as claimed in claim 1 or claim 2, characterized in that the demodulator (6) is constituted by commutating switches, preferably electronic switches (17) connected to an integrator (16) via an amplifier (15).

**Patentansprüche**

1. Anordnung zur Positionsbestimmung von servoüberwachten mechanischen Gliedern, z.B. der Manipulatoren von Industrierobotern mit:

(a) einer Mehrzahl von Winkelumformern in Form von Synchros oder Resolvern, die jeweils zwei Wechselspannungs-Ausgangssignale liefern, die mit Faktoren multipliziert sind, die dem Sinus bzw. dem Cosinus der momentanen Winkelposition $\theta$ des Umformers entsprechen,

(b) einer Subtraktionseinheit (5), die für jeden Umformer ein der Differenz zwischen $\theta$ und einem Winkel $\phi$ entsprechendes Differenzsignal liefert, wobei mit $\phi$ die gewünschte Winkelstellung des betreffenden Umformers bezeichnet ist und wobei die Subtraktionseinheit

(i) einen mit den Wechselspannungs-Ausgangssignalen beaufschlagten Quadrantenselektor (11),

(ii) zwei Multiplikatoreinheiten (12, 13) zur Multiplikation der beiden Ausgangssignale des Quadrantenselektors mit Signalen, die sin $\phi$ bzw. cos $\phi$ entsprechen, und

(iii) einen Differenzverstärker (14) aufweist, dessen Eingänge mit den Ausgängen der Multiplikationseinheiten verbunden sind,

(c) einem Demodulator (6) zur Demodulation des Differenzsignals,

(d) einer mit dem demodulierten Differenzsignal beaufschlagten Signalbewertungsschaltung (7, 8, 10), welche die Subtraktionseinheit (5) mit dem dem Winkel $\phi$ entsprechenden

Signal speist sowie mit

(e) einer Multiplexeinrichtung (1, 2), welche die Umsetzer jeweils einzeln für eine bestimmte Zeit auf die Subtraktionseinheit schaltet, dadurch gekennzeichnet, daß

(f) die Multiplexeinrichtung einen ersten und einen zweiten Multiplexer (1, 2) aufweist, die mit den durch sin $\theta$ bzw. cos $\theta$ modulierten Wechselspannungs-Ausgangssignalen beaufschlagt sind,

(g) die Signalbewertungsschaltung einen mit dem Ausgang des Demodulators (6) verbundenen A/D-Wandler (7) und einen Mikroprozessor (8) aufweist, der mit dem Ausgang des A/D-Wandlers (7) verbunden ist und die gewünschte Winkelstellung $\phi$ errechnet und dass die erhaltenen entsprechenden Digitalwerte über einen Datenbus (9) auf die Multiplikationseinheiten (12, 13) gelangen.

2. Anordnung zur Positionsbestimmung von servoüberwachten mechanischen Gliedern, z.B. der Manipulatoren von Industrie-robotern mit:

(a) einer Mehrzahl von Winkelumformern in Form von Synchros order Resolvern, die jeweils zwei Wechselspannungs-Ausgangssignale liefern, die mit Faktoren multipliziert sind, die dem Sinus bzw. dem Cosinus der momentanen Winkelposition $\theta$ des Umformers entsprechen,

(b) einer Subtraktionseinheit (5), die für jeden Umformer ein der Differenz zwischen $\theta$ und einem Winkel $\phi$ entsprechendes Differenzsignal liefert, wobei mit $\phi$ die gewünschte Winkelstellung des betreffenden Umformers bezeichnet ist,

(c) einen Demodulator (6) zur Demodulation des Differenzsignals,

(d) eine durch das demodulierte Differenzsignal beaufschlagte Signalbewertungsschaltung (7, 8, 10), die die Subtraktionseinheit (6) mit dem dem Winkel $\phi$ entsprechenden Signal speist und

(e) eine Multiplexeinrichtung (1, 2), welche die Umformer einzeln für eine bestimmte Zeit auf die Subtraktionseinheit schaltet, dadurch gekennzeichnet, daß

(f) die Multiplexeinrichtung einen ersten und einen zweiten Multiplexer (1, 2) aufweist, die mit den durch sin $\theta$ bzw. cos $\theta$ modulierten Wechselspannungs-Ausgangssignalen beaufschlagt sind,

(g) die Signalbewertungsschaltung einen mit dem Ausgang des Demodulators (6) verbundenen A/D-Wandler (7) und einen Mikroprozessor (8) aufweist, der mit dem Ausgang des A/D-Wandlers (7) verbunden ist und der die gewünschte Winkelstellung $\phi$ errechnet, und daß

(h) die Subtraktionseinheit (5) folgende Baugruppen aufweist:

(i) zwei Halteglieder (20, 21), die vom Mikroprozessor (8) über einen Datenbus (9) mit Digitalwerten gespeist werden, die dem Sinus bzw. Cosinus der errechneten gewünschten Winkelstellung $\phi$ entsprechen,

(ii) zwei lineare D/A-Wandler (18, 19), welche die mit den sin $\theta$- bzw. cos $\theta$-Faktoren modulierten Wechselspannungs-Ausgangssignale mit den digitalen cos $\theta$- bzw. sin $\phi$-Werten nach deren D/A-Umwandlung multiplizieren, und

(iii) einen Differenzverstärker (14), dessen Eingänge mit den Ausgängen des multiplizierenden D/A-Wandlers (18, 19) verbunden sind.

3. Anordnung nach Anspruch 1 oder 2, dadurch gekennzeichnet, daß der Demodulator (6) durch kommutierende Schalter, vorzugsweise elektronische Schalter (17) gebildet ist, die mit einem Integrator (16) über einen Verstärker (15) verbunden sind.

## Revendications

1. Appareil pour mesurer la position d'organes mécaniques servocommandés, par exemple des manipulateurs de robots industriels, comprenant:

(a) une pluralité de transducteurs de position angulaire se présentant sous la forme de synchros ou résolveurs associés auxdits organes, chacun desdits transducteurs fournissant deux signaux de sortie de courant alternatif modulés par des facteurs représentatifs du sinus et du cosinus, respectivement, de la position angulaire instantanée $\theta$ de ce transducteur,

(b) une unité de soustraction (5) eingendrant pour chaque transducteur un signal de différence représentatif de la différence entre $\theta$ et $\phi$, où $\phi$ désigne la position angulaire désirée du transducteur respectif, ladite unité de soustraction possédant:

(i) un sélecteur de cadran (11) recevant lesdits signaux de sortie de courant alternatif,

(ii) deux unités multiplicatrices (12, 13) multipliant les deux signaux de sortie du sélecteur de cadran par des signaux correspondants à sinus $\phi$ et cosinus $\phi$, respectivement

(iii) un amplificateur différentiel (14) dont les entrées sont connectées aux sorties des unités multiplicatrices,

(c) un démodulateur (6) pour démoduler ledit signal de différence,

(d) un circuit d'évaluation de signal (7, 8, 10) recevant le signal de différence démodulé et fournissant à l'unité de soustraction (5) ledit signal représentatif de $\phi$,

(e) des moyens de multiplexage (1, 2) connectant un transducteur à la fois à l'unité de soustraction, caractérisé par le fait que

(f) les moyens de multiplexage comprennent un premier et un second multiplexeurs (1, 2) recevant les signaux de sortie de courant alternatif modulés en sinus et cosinus, respectivement,

(g) et que le circuit d'évaluation de signal comprend un convertisseur analogique/numérique (7) connecté à la sortie du démodulateur (6), et un microprocesseur (8) connecté à la sortie du convertisseur analogique/numérique (7), ledit microprocesseur calculant la position angulaire désirée $\phi$, la valeur numérique correspondante étant fournie par l'intermédiaire d'un bus de données (9) auxdites unités multiplicatrices (12, 13).

2. Appareil peur mesurer la position d'organes mécaniques servocommandés par exemple des manipulateurs de robots industriels, comprenant:

(a) une pluralité de transducteurs de position angulaire se présentant sous la forme de synchros ou résolvers associes auxdits organes, chacun desdits transducteurs fournissant deux signaux de sortie de courant alternatif modulés par des facteurs représentatifs du sinus et du cosinus, respectivement, de la position angulaire instantanée $\theta$ de ce transducteur,

(b) une unité de soustraction (5) engendrant pour chaque transducteur un signal de différence représentatif de la différence entre $\theta$ et $\phi$, où $\phi$ désigne la position angulaire désirée du transducteur respectif,

(c) un démodulateur (6) pour démoduler ledit signal de différence,

(d) un circuit d'évaluation de signal (7, 8, 10) recevant le signal de différence démodulé et fournissant à l'unité de soustraction (6) ledit signal représentatif de $\phi$,

(e) des moyens de multiplexage (1, 2) connectant un transducteur à la fois à l'unité de soustraction, caractérisé par le fait que

(f) les moyens de multiplexage comprennent un premier et un second multiplexeurs (1, 2) recevant les signaux de sortie de courant alternatif modulés en sinus et cosinus, respectivement,

(g) que le circuit d'évaluation de signal comprend un convertisseur analogique/numérique (7) connecté à la sortie du démodulateur (6), et un microprocesseur (8) connecté à la sortie du convertisseur analogique/numérique (7), ledit microprocesseur calculant la position angulaire désirée $\phi$,

(h) et que l'unité de soustraction (5) comprend:

(i) deux portes (20, 21) connectées au microprocesseur (8) au moyen d'un bus de données (9) fournissant des valeurs numériques représentant le sinus et le cosinus de la position angulaire désirée calculée $\phi$,

(ii) deux convertisseurs numérique/analogique (18, 19) multipliant lesdits signaux de sortie de courant alternatif modulés en sinus et cosinus par lesdites valeurs numériques de cosinus et de sinus respectivement, après leur conversion numérique/analogique,

(iii) un amplificateur différentiel (14) dont les entrées sont connectées aux sorties desdits convertisseurs numérique/analogique multiplicateurs (18, 19).

3. Dispositif selon les revendications 1 ou 2, caractérisé par le fait que le démodulateur (6) est constitué par des interrupteurs de commutation, de préférence des interrupteurs électroniques (17), connectés à un intégrateur (16) par l'intermédiaire d'un amplificateur (15).

Fig .1.

Fig .2.

1

PHASE CONTROL

ERROR SIGNAL FROM SUB

INTERNAL GROUND

17    15

OPERATIONAL AMPLIFIER

16

INTEGRATOR

TO A/D

6

## Fig.3.

1  2  3  4  5  6  7  8  1

## Fig.4.

SIN θ·SINωt

18

D/A

COS θ·SINωt

19

D/A

14

+
−

ERROR SIGNAL

LATCH

LATCH

20

21

(SIN φ)

(COS φ)

ADDRESS LINE 2

ADDRESS LINE 1

14 BITS

FROM MICRO-PROCESSOR

DATABUS

## Fig.5.